# FASCICULE DE BREVET EUROPEEN

(11) **EP 2 491 413 B1**
(45) Date de publication et mention de la délivrance du brevet: **29.08.2018**
(21) Numéro de dépôt: 10771418.0
(22) Date de dépôt: 20.10.2010
(51) Int. Cl.: H03K 17/687, H03K 17/16, H02S 50/10, H01L 31/02

(54) **DISPOSITIF PHOTOVOLTAÏQUE AVEC INTERRUPTEUR(S) ÉLECTRONIQUE(S)**
PV-MODUL MIT ELEKTRONISCHEN SCHALTERN
PHOTOVOLTAIC DEVICE HAVING ELECTRONIC SWITCH(ES)

(30) Priorité: 23.10.2009 FR 0957450
(43) Date de publication de la demande: 29.08.2012
(73) Titulaire: Commissariat à l'Énergie Atomique et aux Énergies Alternatives, 75015 Paris (FR)
(72) Inventeur: CHAINTREUIL, Nicolas, 73800 Montmelian (FR)
(74) Mandataire: Novaimo
(86) Numéro de dépôt international: PCT/EP2010/065762
(87) Numéro de publication internationale: WO 2011/048122

(56) Documents cités:
- EP-A2- 0 679 898
- US-A- 4 382 224
- US-A- 4 528 503
- US-A- 4 970 420
- US-A1- 2008 198 523

## Description

L'invention concerne un dispositif photovoltaïque comprenant un interrupteur électronique et un dispositif de commande. Elle concerne aussi un procédé de diagnostic pour un tel dispositif photovoltaïque permettant de détecter son dysfonctionnement.

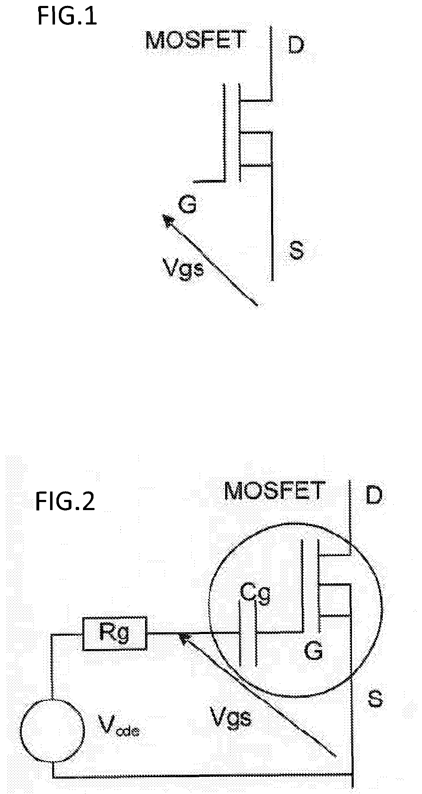

Il est connu d'utiliser un interrupteur électronique de type transistor MOSFET, tel que représenté sur la figure 1. Pour commander la fermeture d'un tel interrupteur, une différence de potentiel dépassant une valeur seuil Vgs est appliquée entre la grille G et la source S. Pour cela, une tension Vcde est généralement appliquée par un échelon dont le front est très court, de l'ordre de quelques nanosecondes (ns). Elle permet de charger la capacité Cg de la grille, qui est une caractéristique intrinsèque du composant utilisé, au travers d'une résistance Rg de l'ordre d'une centaine d'Ohms, selon le schéma électrique représenté en figure 2. En général, la tension de seuil Vgs est comprise entre 12 et 20 V et la tension Vcde est une tension en créneaux dont les fronts varient de 0 à une valeur entre 12 et 22 V, en quelques ns. Au-delà de la tension de seuil Vgs, la capacité Cg de la grille permet de créer une circulation de courant entre G et S, ce qui ferme l'interrupteur. Au-dessous de cette valeur, le courant ne passe pas et l'interrupteur est ouvert. Les valeurs de la résistance Rg et de la capacité Cg déterminent la vitesse de commutation de l'interrupteur, pour une commande de tension donnée. Dans l'état de la technique, les considérations précédentes permettent d'atteindre une ouverture d'un interrupteur en une durée d'environ 10 ns. Les solutions existantes de commande de cette ouverture ont pour objectif de réduire le temps de commutation afin de réduire les pertes par dissipation d'énergie. Or, pour certaines applications, notamment dans le domaine des dispositifs photovoltaïques, ces commandes existantes de l'ouverture d'interrupteurs ne sont pas adaptées.

Le document US 4,382,224 divulgue un dispositif de contrôle d'un module solaire comportant une pluralité de cellules solaires, comportant un circuit de mesure de la courbe I-V du dispositif.

Le document US 2008/0198523 A1 divulgue un dispositif de coupure de protection pour un module solaire comportant une pluralité de cellules solaires montées en série qui fonctionnent dans des conditions normales et également en présence d'ombre. Ainsi, un objet général de l'invention est de proposer une solution différente de commande de l'ouverture d'un interrupteur au sein d'un dispositif photovoltaïque.

A cet effet, l'invention repose sur un dispositif photovoltaïque comprenant un générateur photovoltaïque comprenant plusieurs cellules photovoltaïques, caractérisé en ce qu'il comprend au moins un interrupteur avec un dispositif de commande comprenant une capacité de commande (Ccde) et une résistance de commande (Rcde), relié à l'interrupteur de sorte de ralentir la commande de l'ouverture de l'interrupteur, pour permettre le passage d'au moins une cellule du générateur photovoltaïque d'un mode de fonctionnement en court-circuit à un mode en circuit ouvert ou réciproquement.

L'invention est plus précisément définie par les revendications indépendantes 1 et 7. Ces objets, caractéristiques et avantages de la présente invention seront exposés en détail dans la description suivante d'un mode d'exécution particulier fait à titre non-limitatif en relation avec les figures jointes parmi lesquelles :
La figure 1 représente un interrupteur de type transistor MOSFET selon l'état de la technique.
La figure 2 représente la commande de l'ouverture d'un interrupteur de type MOSFET selon l'état de la technique.
La figure 3 illustre schématiquement un circuit électrique équivalent à une cellule photovoltaïque.
La figure 4 représente la courbe tension-intensité obtenue aux bornes de différentes cellules photovoltaïques.
La figure 5 représente schématiquement le circuit électrique de deux cellules photovoltaïques en série dont l'une est défectueuse.
Les figures 6 et 7 représentent respectivement deux méthodes différentes de diagnostic d'un générateur photovoltaïque à partir des courbes d'évolution de la tension en fonction du temps aux bornes d'un générateur photovoltaïque normal et défectueux.
La figure 8 représente des courbes tension-intensité obtenues aux bornes d'un générateur photovoltaïque selon différents scenarii.
La figure 9 illustre un dispositif photovoltaïque selon un mode d'exécution de l'invention.
La figure 10 représente le circuit électrique mis en oeuvre pour le diagnostic du dispositif photovoltaïque selon le mode d'exécution de l'invention.
La figure 11 représente le circuit électrique mis en oeuvre pour la commande d'un interrupteur selon un mode d'exécution de l'invention.
La figure 12 représente les évolutions de la tension et du courant lors d'une ouverture d'un interrupteur commandé selon le mode d'exécution de l'invention.
La figure 13 représente la courbe U(I) aux bornes d'un module photovoltaïque obtenue par une mesure imparfaite suite à une non optimisation de la commande de l'interrupteur.

Les dispositifs de génération d'énergie à partir de sources intermittentes, comme les générateurs photovoltaïques, sont de plus en plus utilisés. Le coût de leur production dépend de leur autonomie et de leur capacité à diagnostiquer leur défaillance, si possible en temps réel. Les dispositifs existants ne sont pas conçus pour une réaction rapide en cas de défaillance, même quand leur production devient anormalement basse. Pour cette raison, ils nécessitent des opérations de maintenance complexes et coûteuses.

La gestion classique des dispositifs photovoltaïques consiste à observer leur comportement au niveau des systèmes reliés à ces dispositifs, par exemple en mesurant la charge d'une batterie reliée au dispositif ou en mesurant la production électrique obtenue sur un réseau électrique auquel est relié le dispositif. En cas de mesure plus basse que la valeur attendue, il est conclu à une défaillance du dispositif photovoltaïque. Une telle gestion classique présente l'inconvénient d'être imprécise. En effet, elle ne permet pas de faire la distinction entre une baisse normale de production causée par des ombrages ou des conditions météorologiques particulières avec une réelle défaillance du dispositif. De plus, elle ne permet pas de différencier différentes défaillances du dispositif comme une augmentation de la résistance du câblage, par exemple suite à un défaut de connectique ou un arc électrique dans le dispositif, ou une détérioration de la face avant du générateur photovoltaïque, par exemple suite à une délamination ou à de la corrosion, à un ombrage ou à une salissure.

Une solution repose sur l'analyse de l'évolution de la tension d'un générateur photovoltaïque lors de son passage d'un mode de fonctionnement en court-circuit à un mode de fonctionnement en circuit ouvert ou réciproquement. Cette évolution peut être observée par la courbe de la tension en fonction du temps ou par l'analyse de la courbe représentant l'intensité en fonction de la tension au niveau du générateur photovoltaïque lors de ce changement de mode.

Le passage du fonctionnement en court-circuit à un mode de fonctionnement en circuit ouvert nécessite une commande particulière d'un interrupteur, dont le temps d'ouverture doit être suffisamment lent pour permettre la mesure de nombreux points de valeurs de tension et/ou d'intensité, plus lent que la durée habituelle, et suffisamment rapide pour ne pas perturber l'onduleur et le reste du réseau électrique auquel est relié le dispositif photovoltaïque.

Ainsi, l'invention repose sur un interrupteur équipé d'un dispositif de commande qui permet d'atteindre une durée d'ouverture représentant un bon compromis pour répondre aux contraintes précédentes. Son implémentation au sein d'un dispositif photovoltaïque, permet de détecter sa défaillance, selon le principe explicité ci-dessus.

En préambule à la description d'un mode d'exécution du dispositif de commande d'un interrupteur utilisé par l'invention, le principe de détection de la défaillance d'un dispositif photovoltaïque va être détaillé ci-dessous.

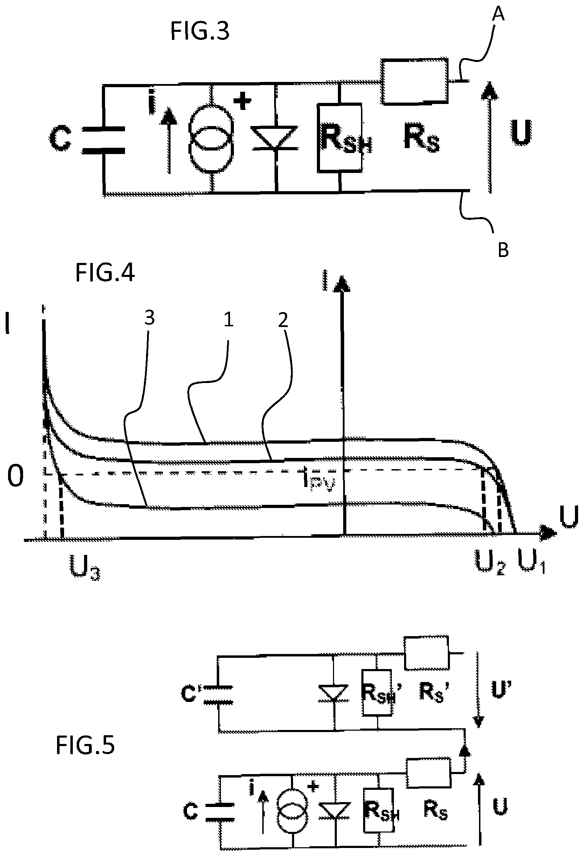

Une cellule photovoltaïque se comporte selon un circuit électrique tel que représenté schématiquement sur la figure 3. Elle fournit un courant I et une tension U sur ses bornes AB de sortie.

La figure 4 représente la courbe de l'intensité I en fonction de la tension U obtenue aux bornes de différentes cellules photovoltaïques. Les courbes 1 et 2 illustrent le cas de cellules photovoltaïques en fonctionnement normal, c'est-à-dire non défectueuses. La courbe 3 illustre la situation d'une cellule photovoltaïque recevant une irradiation insuffisante ou nulle, dite cellule défectueuse. Dans le cas où le courant fourni par un générateur photovoltaïque, qui comprend plusieurs de ces cellules photovoltaïques, s'élève à une valeur I_{PV}, les cellules photovoltaïques en position de fonctionnement normal vont présenter une tension U1, U2 positive à leurs bornes alors qu'une cellule défaillante présentera une tension U3 négative.

La figure 5 illustre schématiquement la représentation électrique d'une cellule en fonctionnement normal placée en série avec une cellule défaillante, dont la tension U' est opposée à la tension U de la cellule en état normal de fonctionnement. Dans une cellule photovoltaïque défectueuse, sa capacité C' est chargée négativement, sa tension opposée peut atteindre plus de 20 fois la valeur de la tension nominale de la cellule et son courant maximal est plus faible que celui d'une autre cellule. Dans le cas de l'ouverture du circuit relié à une telle cellule défectueuse, la tension de la cellule défectueuse va mettre un temps beaucoup plus long que celui d'une cellule normale pour atteindre une valeur nominale positive. Ce temps peut être de l'ordre de 20 à 100 fois plus long.

Ainsi, le phénomène précédent est exploité pour élaborer, selon la réponse d'un générateur photovoltaïque lors de son passage d'un mode de court-circuit à circuit ouvert, un diagnostic de son fonctionnement.

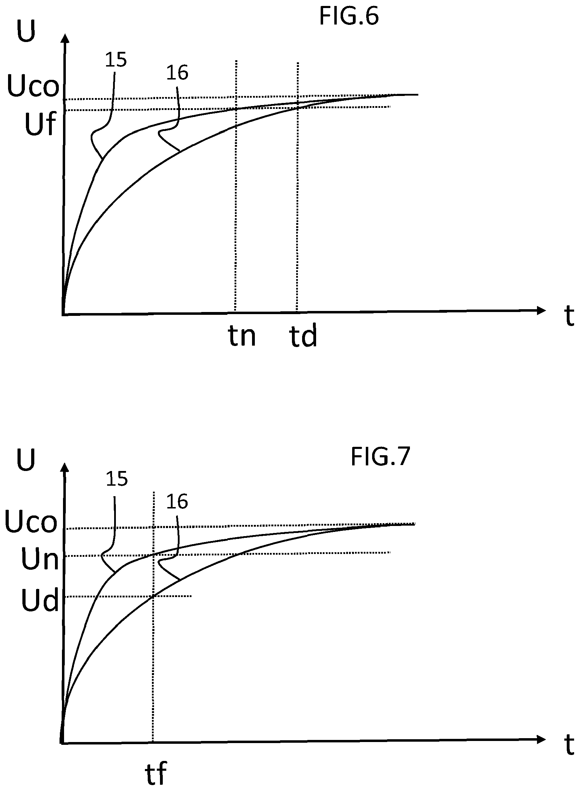

Les figures 6 et 7 représentent des courbes 15, 16 d'évolution de la tension U en fonction du temps t aux bornes d'un générateur photovoltaïque lors de son passage de court-circuit à circuit ouvert, respectivement dans le cas d'un fonctionnement normal et dans le cas d'un fonctionnement défectueux. La courbe normale 15 montre que la tension U converge finalement vers une tension maximale U_{CO}. La courbe 16 montre que la tension d'un générateur défectueux augmente beaucoup moins vite.

Ainsi, une première méthode de diagnostic de l'état du générateur photovoltaïque, représentée sur la figure 6, consiste à observer le temps nécessaire pour atteindre une tension Uf représentant un pourcentage prédéfini de la tension maximale U_{CO}, par exemple 95%. Dans le cas du générateur en fonctionnement normal, la valeur finale prédéfinie Uf est atteinte au bout d'un temps normal tn. Dans le cas du générateur défectueux, la valeur finale prédéfinie Uf est atteinte au bout d'un temps plus long td. Ainsi, la comparaison des temps td et tn permet un diagnostic de l'état du générateur photovoltaïque.

Une seconde méthode, représentée sur la figure 7, consiste à mesurer la tension obtenue pour un temps prédéfini tf. Dans le cas du générateur en fonctionnement normal, une valeur normale Un est atteinte au bout du temps tf. Dans le cas du générateur défectueux, une valeur finale inférieure Ud est atteinte au bout du temps tf. Ainsi, la comparaison des tensions Un et Ud permet un diagnostic de l'état du générateur photovoltaïque.

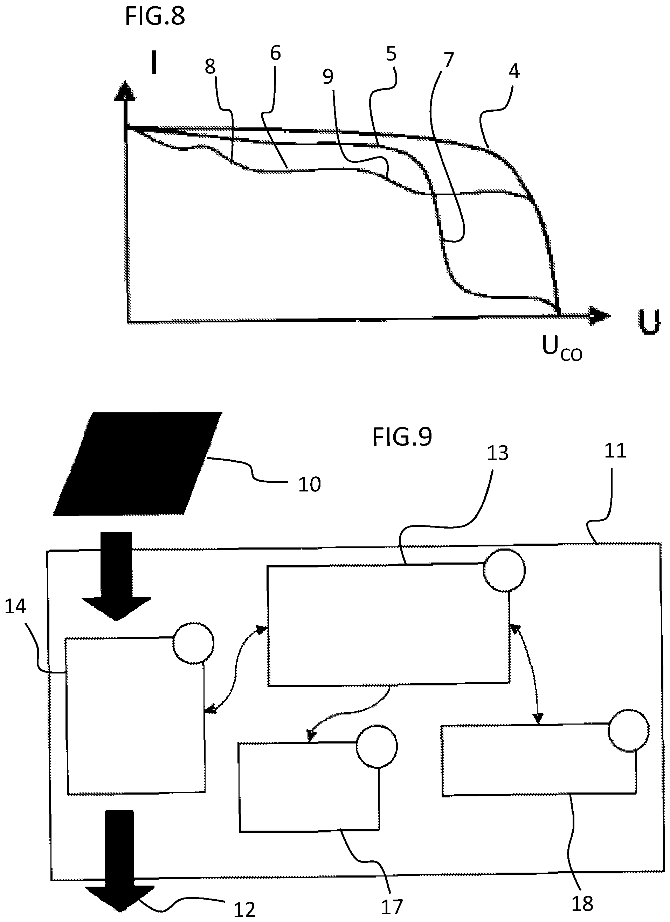

La figure 8 illustre trois courbes U(I) 4, 5, 6 obtenues selon respectivement trois scenarii différents lorsqu'un générateur photovoltaïque passe d'une situation en court-circuit à une situation en circuit ouvert. Chaque courbe U(I) est la somme des courbes U(I) de chacune des cellules photovoltaïques composant le générateur photovoltaïque. Des courbes équivalentes seraient obtenues pour un passage d'une situation en circuit ouvert à une situation en court-circuit.

La courbe 4 représente un générateur photovoltaïque dans lequel toutes les cellules photovoltaïques sont en bon état de fonctionnement. A l'ouverture du circuit, l'intensité va atteindre une valeur nulle alors que la tension atteindra une valeur maximale U_{CO} au bout d'un temps relativement court. La courbe 5 représente la même courbe obtenue dans le cas d'un générateur comprenant au moins une cellule photovoltaïque défectueuse. Cette courbe présente un décrochement 7 au cours duquel l'intensité chute plus rapidement alors que la tension augmente peu. La courbe 6 illustre un autre exemple dans lequel la courbe présente deux décrochements 8, 9, qui indiquent la présence d'au moins deux cellules photovoltaïques défectueuses. Dans tous les cas, la même valeur de tension U_{CO} est finalement atteinte, après un temps toutefois beaucoup plus long dans le cas des courbes 5, 6 pour les générateurs présentant au moins une cellule défaillante comme cela a été explicité ci-dessus. Ces exemples permettent d'illustrer plusieurs situations et enseignent que les courbes U(I) permettent d'obtenir les diagnostics suivants :
- il y a autant de défauts dans le dispositif que de décrochements 7, 8, 9 ;
- plus le décrochement est important, plus la défaillance est importante.

Les explications précédentes vont être exploitées dans un mode d'exécution d'un dispositif photovoltaïque équipé d'un dispositif permettant le diagnostic de son fonctionnement, représenté sur la figure 9.

Le dispositif photovoltaïque de la figure 9 comprend un générateur photovoltaïque 10, qui peut comprendre une ou plusieurs cellules photovoltaïques, relié au réseau électrique par une liaison 12 par l'intermédiaire d'un onduleur 11. Cet onduleur est géré par un microcontrôleur ou CPU 13, dont la fonction principale est de déterminer le point de fonctionnement du générateur photovoltaïque 10 et sa liaison avec le réseau 12. Pour cela, il est en contact avec un bloc 14 de gestion de l'élévation de tension, un convertisseur DC - DC 17, et un bloc 18 de gestion de la publication sur le réseau de la production. Pour remplir sa fonction, le CPU 13 commande régulièrement les mesures suivantes :
- tension et courant fournis par le panneau DC ;
- mesure d'isolement côté DC ;
- mesure de présence réseau ;
- courant et tension injectés sur le réseau AC.

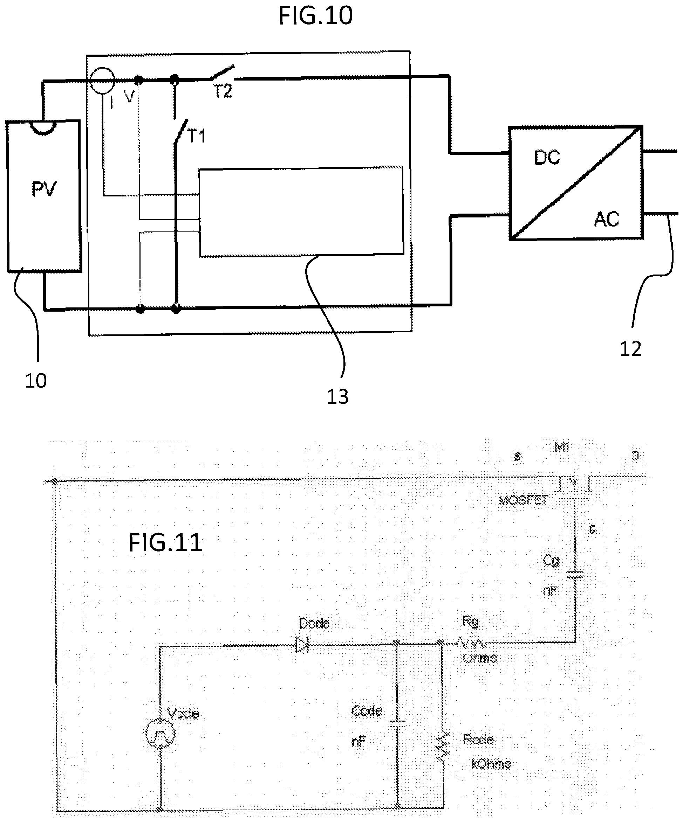

Le dispositif photovoltaïque comprend de plus un dispositif de diagnostic intégré dans l'onduleur 11 décrit ci-dessus, dont le CPU met en oeuvre le procédé de diagnostic pour le générateur photovoltaïque et notamment de détection des défaillances, qui sera décrit plus loin. Le dispositif de diagnostic correspond au schéma électrique représenté sur la figure 10. Le CPU 13 de l'onduleur reçoit les mesures du courant I et de la tension V du générateur photovoltaïque 10 et commande deux interrupteurs T1, T2 selon l'invention, dont le principe de commande sera détaillé par la suite. En situation de fonctionnement normal de production électrique, le commutateur T2 est fermé alors que le commutateur T1 est ouvert. En variante, d'autres dispositifs sont possibles, notamment reposant sur au moins un commutateur. En variante, le dispositif de diagnostic pourrait être intégré dans tout autre boîtier distinct de l'onduleur, comme un boîtier positionné au niveau d'au moins une cellule photovoltaïque par exemple. Selon une variante de réalisation, un tel boîtier pourrait intégrer d'autres fonctions, comme une fonction de détection d'arc électrique au sein du générateur photovoltaïque. Ainsi, le procédé détection de défaillance est mis en oeuvre par un logiciel installé sur un microcontrôleur ou tout support, qui est ensuite intégré au dispositif photovoltaïque, et fonctionne sur la base de la réception de mesures en phase avec la commande du ou des commutateur(s).

Un tel dispositif peut permettre la mise en oeuvre du procédé de son diagnostic selon un premier mode de réalisation comprenant les étapes suivantes :
- ouverture du commutateur T2 pour obtenir le passage du générateur photovoltaïque d'un mode en circuit fermé à un mode en circuit ouvert ;
- mesure de la tension maximale U_{CO} stabilisée, obtenue aux bornes du générateur photovoltaïque au bout d'un certain temps (temps de stabilisation), quand l'intensité est nulle ;
- fermeture du commutateur T1 pour mettre le générateur photovoltaïque en court-circuit puis ouverture du commutateur T1 pour le remettre en circuit ouvert ;
- mesure de la tension U aux bornes du générateur photovoltaïque obtenue au bout d'un temps t prédéfini. Dans ce mode d'exécution, t est choisi égal à 15 microsecondes. Toute valeur relativement proche du temps nécessaire au générateur en situation de fonctionnement non défectueux pour atteindre un pourcentage prédéfini de la tension maximale stabilisée Uco peut convenir, ce temps étant soit mesuré, soit estimé. Le temps t prédéfini sera donc suffisamment grand pour que la tension s'approche de la tension maximale U_{CO} du générateur, au moins pour le cas d'un générateur non défectueux. Ainsi, plus généralement, une valeur comprise entre 10⁻⁷ et 10⁻² secondes pourrait être choisie pour ce temps prédéfini ;
- comparaison de la tension mesurée U avec le pourcentage prédéfini de la tension maximale U_{CO} :
   - si la tension mesurée U atteint un certain pourcentage prédéfini de la tension maximale U_{CO}, alors le générateur est considéré comme fonctionnant normalement et le commutateur T2 est fermé pour remettre le générateur dans sa situation de production électrique normale. Le pourcentage prédéfini est fixé à 95% dans ce mode d'exécution. Il pourrait prendre d'autre valeurs, car il dépend du temps t prédéfini, et par exemple pourrait prendre toute autre valeur de préférence supérieure à 50% ;
   - si la tension mesurée U n'atteint pas le pourcentage prédéfini de la tension maximale U_{CO} alors le générateur est considéré comme défectueux.

En variante, il est possible d'observer la courbe tension-intensité U(I) déterminée pendant que le dispositif passe d'un mode de fonctionnement en court-circuit à un mode en circuit ouvert. Pour cela, les étapes suivantes sont réalisées :
- fermeture du commutateur T1 pour remettre le générateur photovoltaïque en court-circuit puis ouverture du commutateur T1 pour le remettre en circuit ouvert ;
- mesure de plusieurs points de tension et de courant selon une fréquence f_{acq} prédéfinie, cette fréquence se trouvant avantageusement comprise entre 100 kHz et 1 MHz ;
- lorsque la tension atteint la valeur U_{CO}, alors le commutateur T2 est fermé pour remettre le générateur dans sa situation de production électrique normale ;
- les points mesurés sont transmis et analysés par le CPU 13 du dispositif photovoltaïque, qui peut ainsi déduire le nombre de défauts et l'importance de la dégradation.

Selon une variante de réalisation en mode réciproque, seule la première étape est modifiée ; le commutateur T1 est d'abord ouvert puis fermé de sorte de générer un passage d'un circuit ouvert vers un court-circuit.

En variante, les deux modes d'exécution décrits précédemment peuvent être cumulés. Par exemple, le premier mode d'exécution reposant sur l'analyse de l'évolution en fonction du temps de la tension lorsqu'il passe d'un mode de fonctionnement en court-circuit à un mode de fonctionnement en circuit ouvert peut être suivi dans le cas où un défaut est détecté de la détermination et de l'observation de l'évolution de la courbe U(I) afin d'en déduire des informations complémentaires sur les défauts du dispositif.

Selon l'invention, le temps nécessaire pour la mise en oeuvre du diagnostic est suffisamment faible pour permettre son exécution sans l'arrêt complet de l'onduleur 11, qui nécessiterait alors un temps important dans le cas contraire, pouvant atteindre plusieurs minutes, pour produire de nouveau sa puissance maximale. Pour cela, il faut noter que l'onduleur comprend un bus capacitif permettant de stocker de l'énergie. Pour ne pas perturber son fonctionnement, il convient de tracer la courbe U(I) en moins de 10 ms. Toutefois, la durée habituelle d'ouverture d'un interrupteur de 10 ns est trop rapide pour permettre un nombre satisfaisant de mesures et tracer une courbe U(I) satisfaisante. Ainsi, l'invention propose de retarder l'ouverture d'un tel interrupteur grâce à un dispositif de commande particulier pour atteindre une ouverture en un temps compris entre 10 ns et 10 ms.

La figure 11 représente le dispositif de commande d'un interrupteur selon un mode d'exécution de l'invention. Ce dispositif repose sur l'ajout d'une résistance Rcde, dont la fonction est d'augmenter la durée de la décharge de la capacité de grille Cg du transistor, une capacité Ccde, dont la fonction est de ralentir la chute de la tension de commande, et une diode Dcde, dont la fonction est d'éviter la décharge de la capacité de grille Cg vers le générateur de tension Vcde. La capacité de commande (Ccde) et la résistance de commande (Rcde) sont disposées en parallèle et reliées à la borne d'entrée de l'ensemble formé par la résistance de grille (Rg) et la capacité de grille (Cg).

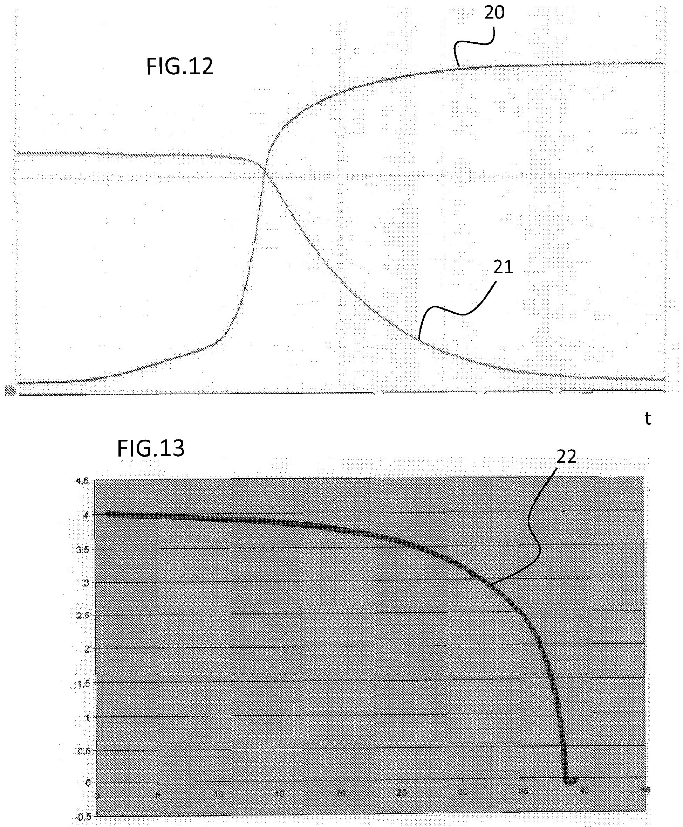

A titre d'exemple, considérons une tension en créneaux montants et descendants variant entre 0 et 17V en quelques ns. Lors d'une commande d'ouverture directe du transistor, par l'intermédiaire de la diode Dcde, la valeur de la tension de commande Vcde passe à 0 V. La capacité de commande Ccde, dont la valeur est de 220 nF, se décharge lentement au travers de la résistance de commande Rcde, dont la valeur est de 12 kOhms. Dans le même temps, la capacité Cg du transistor se décharge aussi lentement, la diode empêchant une éventuelle décharge par l'alimentation de tension Vcde. En remarque, cette diode est optionnelle. Pour l'utilisation de ce dispositif avec un module photovoltaïque silicium poly-cristallin, le temps d'ouverture est de 800 µs. Durant cette ouverture, le dispositif mesure une centaine de points, de préférence au moins 10 points, permettant de tracer les courbes 20 d'évolution de la tension et 21 d'évolution du courant, durant ces 800 µs d'ouverture, représentées sur la figure 12. Ces mesures permettent ainsi d'obtenir une courbe U(I) précise, semblable à la courbe 4 de la figure 8.

Naturellement, les valeurs numériques précédentes sont données à titre d'exemple, et il convient de les adapter aux technologies d'interrupteur et de modules photovoltaïques utilisés, pour lesquels les capacités varient d'une technologie à une autre en influant sur la forme des courbes U(I). Ainsi, il est opportun de ralentir de manière plus importante la commutation des interrupteurs associés à un module dont la capacité parasite est élevée. Pour cela, les valeurs de la capacité Ccde et de la résistance Rcde de commande, qui déterminent le niveau de ralentissement de l'ouverture de l'interrupteur avec lequel ces composants sont associés, seront adaptées aux modules photovoltaïques à équiper, à partir de tests particuliers effectués au préalable sur ces modules. Plus la valeur de la capacité de commande est élevée, plus le temps de commutation le sera aussi et plus la courbe U(I) pourra être obtenue de manière précise. Avantageusement, la capacité de commande Ccde aura une valeur comprise entre 10 et 10000 nF et la résistance de commande Rcde aura une valeur supérieure à 1 kOhm. La figure 13 représente à titre d'exemple une courbe U(I) imparfaite obtenue dans le cas d'un paramétrage non optimal des composants du dispositif de commande de l'interrupteur, sur laquelle la zone 22 correspondant au point de puissance maximum est beaucoup moins marquée. Ainsi, il convient notamment de choisir les paramètres Rcde et Ccde du dispositif de commande de l'interrupteur de manière à obtenir un coude précis de la courbe U(I). Dans la pratique, ces valeurs seront déterminées en fonction du ralentissement souhaité de la commutation et seront telles d'avoir pour effet d'obtenir une ouverture entre 10 ns et 10 ms, une valeur comprise 1 et 5000 µs étant avantageuse. Elles peuvent être déterminées empiriquement pour s'adapter parfaitement à l'environnement et à l'interrupteur sur lequel la commande de ralentissement va s'appliquer.

Un procédé de diagnostic pour le dispositif photovoltaïque a été décrit à titre d'exemple. Bien entendu, d'autres variantes sont possibles pour ce diagnostic, reposant sur la variation du temps nécessaire pour atteindre la tension maximale U_{CO} aux bornes du générateur en situation de circuit ouvert. Cette tension maximale n'est pas obligatoirement mesurée à chaque mise en oeuvre du procédé de diagnostic mais elle peut par exemple être mesurée une seule fois lorsque le générateur est neuf, en fonctionnement normal non défectueux, et mémorisée. De même, le temps nécessaire pour atteindre cette valeur peut être mesuré simultanément, et mémorisé pour servir de base aux étapes de diagnostic.

Ainsi, une variante possible du premier mode d'exécution du procédé de diagnostic du générateur peut consister à systématiquement attendre, lors du passage en circuit ouvert du générateur, que la tension atteigne la tension maximale, mesurer le temps nécessaire et le comparer au temps normal en cas de bon fonctionnement. Si ce temps dépasse le temps normal d'un pourcentage prédéfini, alors le générateur est considéré comme étant défectueux.

Le procédé de diagnostic a été décrit sur la base d'un dispositif de diagnostic correspondant au schéma électrique représenté sur la figure 10. Selon une variante avantageuse, le diagnostic pourrait être fait en utilisant la structure d'entrée d'un onduleur photovoltaïque. Classiquement, ces onduleurs utilisent des composants d'électronique de puissance, soit en série, soit en parallèle, soit les deux, pouvant permettre de déconnecter la partie onduleur (étage convertisseur DC/AC) de la partie hacheur (étage convertisseur DC/DC) de l'appareil « onduleur photovoltaïque » et/ou de réaliser la fonction de conversion DC/DC. Ces composants peuvent effectuer le passage de court-circuit à circuit ouvert du (des) générateur(s) photovoltaïque(s) connecté(s) en entrée et ainsi permettre de faire le diagnostic. Cette fonctionnalité pourrait ainsi être mise en oeuvre facilement et principalement grâce à des adaptations logicielles des onduleurs existants.

En remarque complémentaire, l'objectif habituel d'un dispositif photovoltaïque est de produire de l'énergie électrique en réduisant les pertes du système au maximum, et donc en utilisant des modes de commutations rapides dans les convertisseurs DC/DC ou DC/AC mentionnés ci-dessus pour la conversion de puissance. De plus, les dispositifs de mesure actuellement utilisés ne sont pas actifs mais passifs, c'est-à-dire qu'ils n'interviennent pas sur le fonctionnement direct du dispositif photovoltaïque. Au contraire, le dispositif photovoltaïque de l'invention intègre une partie active, qui va directement modifier son fonctionnement. De plus, cette intervention active est prévue pour être suffisamment lente pour atteindre une mesure significative de l'évolution de la tension en fonction du temps dans les situations décrites précédemment, mais aussi suffisamment rapide pour ne pas perturber le reste du réseau électrique. Suite aux explications données précédemment, l'homme du métier pourra choisir les paramètres qui déterminent ce temps de mesure. Avantageusement, il les choisira pour atteindre une durée totale de la mesure, soit le tracé de l'évolution de la tension en fonction du temps ou du courant, comprise entre 0.5 et 1 ms.

## Revendications

1. Dispositif photovoltaïque comprenant un générateur photovoltaïque comprenant plusieurs cellules photovoltaïques, **caractérisé en ce qu'**il comprend :
- un interrupteur (T1) en parallèle sur au moins une cellule du générateur photovoltaïque, cet interrupteur étant un transistor MOS comprenant une capacité de grille (Cg) et une résistance de grille (Rg) en série, et
- un dispositif de commande relié à l'interrupteur comprenant une capacité de commande (Ccde) et une résistance de commande (Rcde), la capacité de commande (Ccde) et la résistance de commande (Rcde) étant disposées en parallèle à la borne d'entrée de l'ensemble formé par la résistance de grille (Rg) et la capacité de grille (Cg) de l'interrupteur, de sorte de ralentir la commande de l'ouverture de l'interrupteur, pour permettre le passage d'au moins une cellule du générateur photovoltaïque d'un mode de fonctionnement en court-circuit à un mode en circuit ouvert ou réciproquement, et
- un moyen d'observation de l'évolution de la tension (U) en fonction du courant (I) aux bornes du dispositif photovoltaïque pendant qu'il passe du mode de fonctionnement en court-circuit à un mode en circuit ouvert, ou réciproquement d'un mode de fonctionnement en circuit ouvert à un mode en court-circuit.

2. Dispositif photovoltaïque selon la revendication précédente, **caractérisé en ce qu'**il comprend un autre interrupteur (T2) apte à relier ou non le générateur photovoltaïque à une charge extérieure comme une batterie ou un réseau électrique.

3. Dispositif photovoltaïque selon la revendication 1 ou 2, **caractérisé en ce que** la capacité de commande (Ccde) présente une valeur comprise entre 10 et 10000 nF et la résistance de commande (Rcde) une valeur supérieure à 1 kOhm.

4. Dispositif photovoltaïque selon l'une des revendications précédentes, **caractérisé en ce que** le dispositif de commande comprend de plus une diode (Dcde), apte à éviter la décharge de la capacité de grille (Cg) vers un générateur de tension (Vcde) qui serait disposé aux bornes de l'ensemble formé par la capacité de commande (Ccde) et la résistance de commande (Rcde) pour transmettre une commande de tension à l'interrupteur.

5. Dispositif photovoltaïque selon l'une des revendications précédente, **caractérisé en ce que** la capacité de commande (Ccde) et la résistance de commande (Rcde) ont des valeurs aptes à un ralentissement de l'ouverture de l'interrupteur pour atteindre son ouverture entre 10 ns et 10 ms.

6. Dispositif photovoltaïque selon la revendication précédente, **caractérisé en ce que** la capacité de commande (Ccde) et la résistance de commande (Rcde) ont des valeurs aptes à un ralentissement de l'ouverture de l'interrupteur pour atteindre son ouverture entre 1 et 5000 µs.

7. Procédé de diagnostic pour un dispositif photovoltaïque, **caractérisé en ce qu'**il comprend une étape de fermeture ou ouverture d'un interrupteur (T1) en parallèle sur au moins une cellule du générateur photovoltaïque, cet interrupteur étant un transistor MOS comprenant une capacité de grille (Cg), et une résistance de grille (Rg) en série, par l'intermédiaire d'un dispositif de commande relié à l'interrupteur comprenant une capacité de commande (Ccde) et une résistance de commande (Rcde), disposé en parallèle à la borne d'entrée de l'ensemble formé par la résistance de grille (Rg) et la capacité de grille (Cg) de l'interrupteur, de sorte de ralentir la commande de l'interrupteur, et une étape d'observation de l'évolution de la tension (U) en fonction du courant (I) aux bornes du dispositif photovoltaïque pendant qu'il passe du mode de fonctionnement en court-circuit à un mode en circuit ouvert, ou réciproquement d'un mode de fonctionnement en circuit ouvert à un mode en court-circuit, suite à l'étape précédente.

8. Procédé de diagnostic pour un générateur photovoltaïque selon la revendication précédente, **caractérisé en ce qu'**il comprend la mesure d'au moins 10 points de tension (U) et/ou d'intensité (I) pendant le passage d'un mode de fonctionnement en court-circuit à un mode en circuit ouvert ou inversement en une durée comprise entre 10 ns et 10 ms.

9. Procédé de diagnostic pour un générateur photovoltaïque selon l'une des revendications 7 à 8, **caractérisé en ce qu'**il comprend la mesure de points de tension (U) et/ou d'intensité (I) pendant le passage d'un mode de fonctionnement en court-circuit à un mode en circuit ouvert ou inversement en une durée comprise entre 500 µs et 1 ms.

10. Procédé de diagnostic pour un générateur photovoltaïque selon l'une des revendications 7 à 9, **caractérisé en ce qu'**il comprend une étape de détection des décrochements (7, 8, 9) de la courbe tension-intensité pour en déduire le nombre de défauts ainsi que l'importance de la défaillance.

11. Procédé de diagnostic pour un générateur photovoltaïque selon l'une des revendications 7 à 10, **caractérisé en ce qu'**il comprend les étapes supplémentaires suivantes :
- ouverture d'un premier interrupteur (T2) (en anglais switch) pour obtenir le passage du générateur photovoltaïque de la position de circuit fermé à celle de circuit ouvert, en le déconnectant de sa charge ;
- mesure de la tension maximale (U_{CO}) stabilisée, obtenue aux bornes du générateur photovoltaïque ;
- fermeture d'un second interrupteur (T1) pour mettre le générateur photovoltaïque en court-circuit puis ouverture de ce second interrupteur (T1) pour le remettre en circuit ouvert ;
- mesure de la tension (U) et du courant (I) aux bornes du générateur photovoltaïque jusqu'à ce que la tension (U) atteigne la tension maximale (U_{CO}) pour obtenir la courbe U(I) ;
- fermeture du premier interrupteur (T2) pour remettre le générateur photovoltaïque dans sa situation de production électrique normale en liaison avec sa charge.

## Patentansprüche

1. Photovoltaische Vorrichtung, umfassend einen photovoltaischen Generator, umfassend mehrere photovoltaische Zellen, **dadurch gekennzeichnet, dass** diese umfasst:
- einen Schalter (T1) parallel auf mindestens einer Zelle des photovoltaischen Generators, wobei dieser Schalter ein MOS-Transistor ist, umfassend eine Gate-Kapazität (Cg) und einen Gate-Widerstand (Rg) in Serie, und
- eine Steuervorrichtung, die mit dem Schalter verbunden ist, umfassend eine Steuerkapazität (Ccde) und einen Steuerwiderstand (Rede), wobei die Steuerkapazität (Ccde) und der Steuerwiderstand (Rcde) parallel zum Eingangsanschluss der Einheit, die von dem Gate-Widerstand (Rg) und der Gate-Kapazität (Cg) des Schalters gebildet wird, derart angeordnet sind, dass die Steuerung der Öffnung des Schalters verlangsamt wird, um den Übergang mindestens einer Zelle des photovoltaischen Generators von einem Kurzschluss-Betriebsmodus in einen offenen Schaltungsmodus zu gestatten oder umgekehrt, und
- ein Mittel zur Beobachtung der Entwicklung der Spannung (U) als Funktion des Stroms (I) an den Anschlüssen der photovoltaischen Vorrichtung, während sie von dem Kurzschluss-Betriebsmodus in einen offenen Schaltungsmodus oder umgekehrt von einem Betriebsmodus mit offener Schaltung in einen Kurzschlussmodus übergeht.

2. Photovoltaische Vorrichtung nach dem vorhergehenden Anspruch, **dadurch gekennzeichnet, dass** diese einen weiteren Schalter (T2) umfasst, der geeignet ist, den photovoltaischen Generator mit einer externen Ladung, wie einer Batterie oder einem Stromnetz, zu verbinden.

3. Photovoltaische Vorrichtung nach Anspruch 1 oder 2, **dadurch gekennzeichnet, dass** die Steuerkapazität (Ccde) einen Wert zwischen 10 und 10000 nF und der Steuerwiderstand (Rcde) einen Wert von mehr als 1 kOhm aufweist.

4. Photovoltaische Vorrichtung nach einem der vorhergehenden Ansprüche, **dadurch gekennzeichnet, dass** die Steuervorrichtung außerdem eine Diode (Dcde) umfasst, die geeignet ist, die Entladung der Gate-Kapazität (Cg) zu einem Spannungsgenerator (Vcde) zu vermeiden, der an den Anschlüssen der Einheit angeordnet ist, die von der Steuerkapazität (Ccde) und dem Steuerwiderstand (Rcde) gebildet wird, um eine Spannungssteuerung an den Schalter zu übertragen.

5. Photovoltaische Vorrichtung nach einem der vorhergehenden Ansprüche, **dadurch gekennzeichnet, dass** die Steuerkapazität (Ccde) und der Steuerwiderstand (Rcde) Werte aufweisen, die für eine Verlangsamung der Öffnung des Schalters geeignet sind, um seine Öffnung zwischen 10 ns und 10 ms zu erzielen.

6. Photovoltaische Vorrichtung nach dem vorhergehenden Anspruch, **dadurch gekennzeichnet, dass** die Steuerkapazität (Ccde) und der Steuerwiderstand (Rcde) Werte aufweisen, die für eine Verlangsamung der Öffnung des Schalters geeignet sind, um seine Öffnung zwischen 1 und 5000 µs zu erzielen.

7. Diagnoseverfahren für eine photovoltaische Vorrichtung, **dadurch gekennzeichnet, dass** dieses umfasst: einen Schritt des Schließens oder Öffnens eines Schalters (T1) parallel auf mindestens einer Zelle des photovoltaischen Generators, wobei dieser Schalter ein MOS-Transistor ist, umfassend eine Gate-Kapazität (Cg) und einen Gate-Widerstand (Rg) in Serie, mit Hilfe einer Steuervorrichtung, die mit dem Schalter verbunden ist, umfassend eine Steuerkapazität (Ccde) und einen Steuerwiderstand (Rede), die parallel am Eingangsanschluss der Einheit, die von dem Gate-Widerstand (Rg) und der Gate-Kapazität (Cg) des Schalters gebildet wird, derart angeordnet sind, dass die Steuerung des Schalters verlangsamt wird, und einen Schritt des Beobachtens der Entwicklung der Spannung (U) als Funktion des Stroms (I) an den Anschlüssen der photovoltaischen Vorrichtung, während sie von dem Kurzschluss-Betriebsmodus in einen offenen Schaltungsmodus oder umgekehrt von einem Betriebsmodus mit offener Schaltung in einen Kurzschlussmodus übergeht, nach dem vorhergehenden Schritt.

8. Diagnoseverfahren für einen photovoltaischen Generator nach dem vorhergehenden Anspruch, **dadurch gekennzeichnet, dass** dieses die Messung von mindestens 10 Punkten einer Spannung (U) und/oder einer Intensität (I) während des Übergangs von einem Kurzschluss-Betriebsmodus in einen offenen Schaltungsmodus oder umgekehrt in einer Dauer zwischen 10 ns und 10 ms umfasst.

9. Diagnoseverfahren für einen photovoltaischen Generator nach einem der Ansprüche 7 bis 8, **dadurch gekennzeichnet, dass** dieses die Messung von Punkten einer Spannung (U) und/oder einer Intensität (I) während des Übergangs von einem Kurzschluss-Betriebsmodus in einen offenen Schaltungsmodus oder umgekehrt in einer Dauer zwischen 500 µs und 1 ms umfasst.

10. Diagnoseverfahren für einen photovoltaischen Generator nach einem der Ansprüche 7 bis 9, **dadurch gekennzeichnet, dass** dieses einen Schritt der Detektion eines Abfalls (7, 8, 9) der Spannung-Intensitäts-Kurve umfasst, um daraus auf die Anzahl von Fehlern sowie die Bedeutung eines Ausfalls zu schließen.

11. Diagnoseverfahren für einen photovoltaischen Generator nach einem der Ansprüche 7 bis 10, **dadurch gekennzeichnet, dass** dieses die folgenden ergänzenden Schritte umfasst:
- Öffnen eines ersten Schalters (T2) (engl. switch), um den Übergang des photovoltaischen Generators von der geschlossenen Schaltungsposition in die geöffnete Schaltungsposition zu erhalten, indem er von seiner Ladung getrennt wird;
- Messen der maximalen stabilisierten Spannung (U_{CO}), die an den Anschlüssen des photovoltaischen Generators erhalten wird;
- Schließen eines zweiten Schalters (T1), um den photovoltaischen Generator kurzzuschließen, dann Öffnen dieses zweiten Schalters (T1), um ihn erneut in eine offene Schaltung zu versetzen;
- Messen der Spannung (U) und des Stroms (I) an den Anschlüssen des photovoltaischen Generators, bis die Spannung (U) die maximale Spannung (U_{CO}) erreicht, um die Kurve U(I) zu erhalten;
- Schließen des ersten Schalters (T2), um den photovoltaischen Generator erneut in seinen Normalzustand der Erzeugung von Strom in Verbindung mit seiner Ladung zu versetzen.

## Claims

1. Photovoltaic device comprising a photovoltaic generator comprising a number of photovoltaic cells, **characterized in that** it comprises :
- at least one switch in parallel on at least one cell of the photovoltaic generator, said switch being an MOS transistor, comprising a gate capacitor (Cg) and a gate resistor (Rg) in series, and
- a control device linked to the switch comprising a control capacitor (Ccde) and a control resistor (Rcde), the control capacitor (Ccde) and the control resistor (Rcde) being arranged in parallel at the input terminal of the assembly formed by the gate resistor (Rg) and the gate capacitor (Cg), so as to slow down the control of the opening of the switch, to allow at least one cell of the photovoltaic generator to switch from a short-circuit operating mode to an open-circuit mode, or vice versa, and
- an observation means of the trend of the voltage (U) as a function of the current (I) at the terminals of the photovoltaic device while it switches from a short-circuit operating mode to an open-circuit, or vice versa from an open-circuit operating mode to a short-circuit mode.

2. Photovoltaic device according to the preceding claim, **characterized in that** it comprises another switch (T2) which is capable of linking or not linking the photovoltaic generator to an external load such as a battery or an electricity network.

3. Photovoltaic device according to the claim 1 or 2, **characterized in that** the control capacitor (Ccde) has a value between 10 and 10000 nF and the control resistor (Rcde) has a value greater than 1 kOhm.

4. Photovoltaic device according to one of the preceding claims, **characterized in that** the control device also comprises a diode (Dcde), capable of preventing the discharging of the gate capacitor (Cg) to a voltage generator (Vcde) which would be arranged at the terminals of the assembly formed by the control capacitor (Ccde) and the control resistor (Rcde) to transmit a voltage command to the switch.

5. Photovoltaic device according to one of the preceding claims, **characterized in that** the control capacitor (Ccde) and the control resistor (Rcde) have values capable of slowing down the opening of the switch to achieve its opening between 10 ns and 10 ms.

6. Photovoltaic device according to the preceding claim, **characterized in that** the control capacitor (Ccde) and the control resistor (Rcde) have values capable of slowing down the opening of the switch to achieve its opening between 1 and 5000 µs.

7. Diagnostic method for a photovoltaic device, **characterized in that** it comprises a step of closing or opening a switch in parallel on at least one cell of the photovoltaic generator, said switch being an MOS transistor, comprising a gate capacitor (Cg) and a gate resistor (Rg) in series, by means of a control device linked to the switch comprising a control capacitor (Ccde) and a control resistor (Rcde), arranged in parallel at the input terminal of the assembly formed by the gate resistor (Rg) and the gate capacitor (Cg), so as to slow down the control of the switch, and a step of observing the trend of its voltage (U) as a function of the current (I) at the terminals of the photovoltaic generator while it switches from a short-circuit operating mode to an open-circuit mode using a control device of at least one switch, or vice versa from an open-circuit operating mode to a short-circuit mode, following preceding step.

8. Diagnostic method for a photovoltaic generator according to the preceding claim, **characterized in that** it comprises the measurement of at least 10 points of voltage (U) and/or of current (I) during the switch from a short-circuit operating mode to an open-circuit mode or vice versa within a time of between 10 ns and 10 ms.

9. Diagnostic method for a photovoltaic generator according to one of claims 7 to 8, **characterized in that** it comprises the measurement of points of voltage (U) and/or of current (I) during the switch from a short-circuit operating mode to an open-circuit mode or vice versa within a duration of between 500 µs and 1 ms.

10. Diagnostic method for a photovoltaic generator according to one of Claims 7 to 9, **characterized in that** it comprises a step of detecting discontinuities (7, 8, 9) in the voltage-current curve to deduce therefrom the number of defects and the significance of the failing.

11. Diagnostic method for a photovoltaic generator according to one of Claims 7 to 10, **characterized in that** it comprises the following additional steps:
- opening of a first switch (T2) in order to switch the photovoltaic generator from the closed-circuit position to the open-circuit position, by disconnecting it from its load;
- measurement of the stabilised maximum voltage (U_{CO}) obtained at the terminals of the photovoltaic generator;
- closure of a second switch (T1) to set the photovoltaic generator to short-circuit mode, then opening of this second switch (T1) to reset it to open-circuit mode;
- measurement of the voltage (U) and of the current (I) at the terminals of the photovoltaic generator until the voltage (U) reaches the maximum voltage (U_{CO}) to obtain the curve U(I);
- closure of the first switch (T2) to reset the photovoltaic generator to its normal electrical production condition linked with its load.
